# FASCICULE DE BREVET EUROPEEN

(11) **EP 1 958 490 B1**
(45) Date de publication et mention de la délivrance du brevet: **27.10.2010**
(21) Numéro de dépôt: 06830079.7
(22) Date de dépôt: 22.11.2006
(51) Int. Cl.: H05K 7/14

(54) **BOITIER D'APPAREILLAGE ELECTRONIQUE RIGIDE ET LEGER**
STARRES UND LEICHTGEWICHTIGES GEHÄUSE FÜR EIN ELEKTRONISCHES GERÄT
RIGID AND LIGHTWEIGHT ELECTRONIC EQUIPMENT CASING

(30) Priorité: 07.12.2005 FR 0512425
(43) Date de publication de la demande: 20.08.2008
(73) Titulaire: THALES, 92200 Neuilly sur Seine (FR)
(72) Inventeur: SARNO, Claude, F-26800 Etoile/sur/Rhone (FR); JARNIAS, Christophe, F-26000 Valence (FR); MARFISI, Pierre, F-26120 Chabeuil (FR)
(74) Mandataire: Esselin, Sophie
(86) Numéro de dépôt international: PCT/EP2006/068735
(87) Numéro de publication internationale: WO 2007/065789

(56) Documents cités:
- EP-A- 1 011 300
- US-A1- 2004 100 767

## Description

Le domaine de l'invention est celui des boîtiers d'appareillage électronique et plus particulièrement les boîtiers d'appareillage électronique équipant des porteurs et notamment des aéronefs.

Des équipements électroniques sont embarqués en très grand nombre à bord des aéronefs pour assurer des fonctions multiples. Le plus souvent, ces équipements sont répartis dans l'aéronef suivant une architecture modulaire qui facilite à la fois leur conception et leur interchangeabilité. Selon ce type d'architecture, les modules sont des ensembles d'appareillage électronique, par exemples des cartes de circuits imprimés dont les faces comportent des composants électroniques, les modules sont logés à l'intérieur d'une cavité formée par un boîtier, fréquemment métallique et de forme parallélépipédique. Le boîtier assure d'une part, l'accueil et le guidage des appareillage électronique à l'intérieur de la cavité, d'autre part, le boîtier est conformé pour se fixer mécaniquement, par exemple de manière amovible, à un châssis d'accueil placé, à cet effet, sur le porteur. La rigidité du boîtier protège les appareillage électronique qu'il héberge des environnement vibratoires sévères. Le boîtier assure également, par ses parois formant une cage de Faraday, une protection contre les environnement électromagnétiques perturbés que l'on rencontre à l'intérieur des porteurs en fonctionnement. Il évite aussi que les appareillage électronique internes au boîtier perturbent les équipements placés à l'extérieur du boîtier.

Dans le domaine des aéronefs civils ou militaires, les boîtiers et les châssis d'accueil respectent, le plus souvent, des normes prédéterminées conformément aux exigences des constructeurs des aéronefs. Les normes couramment utilisés sont ARINC 600, ARINC 650, AER 300 ou d'autres standards spécifiques à chaque avionneur. Ces normes spécifient, les cotes d'encombrements à respecter par des boîtiers d'appareillage électronique, ainsi que leurs interfaces mécaniques, leurs interfaces électriques et les positions et les tailles d'ouvertures figurant sur certaines parois des boîtiers. L'avionneur fait le choix d'une norme et équipe le porteur, en conséquence, de châssis d'accueil répondant à la norme.

En général, les boîtiers répondant aux normes ARINC ou AER sont réalisés par des assemblages de tôle pliées en aluminium (voir par example EP 1011300A2). La rigidité de tels boîtiers est en effet suffisante étant données le faible niveau des contraintes mécaniques rencontrées dans le domaine de l'aviation civile, Le niveau des contraintes d'environnement rencontrées dans le domaine des aéronefs militaires est, en général, plus sévère et requiert une rigidité des parois du boîtier supérieure à celle obtenue par des assemblages de tôles. On répond à ce besoin en réalisant des structures massives en alliage d'aluminium obtenues par un procédé de fonderie ou d'usinage dans la masse.

Des hautes performances en dissipation thermique, rigidité et protection électromagnétique permettent aux boîtiers d'apporter, aux ensembles d'appareillage électronique embarqués qu'ils hébergent, un conditionnement garantissant une survie dans les environnement rencontrés en conditions opérationnelles. On cherche de plus, pour équiper des aéronefs aussi bien civils que militaires, à réaliser des boîtier qui soient légers. En effet, étant donné le nombre très élevé des ensembles d'appareillage électronique embarqués sur un aéronef, la masse cumulée des boîtiers qu'un aéronef contient peut atteindre plusieurs dizaines de kilogrammes, par exemple 30 à 40 kg sur un hélicoptère militaire. Toute action visant réduire la masse des boîtiers se traduit par un allègement précieux de l'aéronef, pouvant être réalloué au profit de l'intégration de nouvelles fonctions embarquées ou pouvant être exploité aux fins d'une amélioration des performances du porteur (consommation réduite en carburant, rayon d'action allongé, etc..).

Pour réaliser des boîtiers légers, une première approche vise à réduire l'épaisseur des parois des boîtiers selon l'état de la technique dont la valeur vaut, en général, 2 millimètres, ce qui constitue une épaisseur moyenne difficile à réduire avec un alliage d'aluminium, une deuxième approche consiste à utiliser des matériaux innovants, à faible densité pour les substituer aux alliages d'aluminium employés dans l'état de la technique.

L'approche d'un allègement de masse par réduction d'épaisseur des parois du boîtier, pour réduire par exemple une épaisseur de paroi de 2 à 1,5 millimètre requiert l'emploi de matériaux dont la densité équivaut à celle de l'aluminium (dₐₗᵤₘᵢₙᵢᵤₘ ≈ 2.7) et dont le module de Young est au minimum deux fois supérieur à celui de l'aluminium, c'est à dire supérieur à 150 Gpa, de manière à conserver une rigidité équivalente dans les zones principales de maintien des boîtiers (angles, points d'attache mécanique, etc...). Les composites à matrice métallique (CMM), comme par exemple une matrice en alliage d'aluminium chargé en carbure de silicium (AUSiC), sont des matériaux qui répondent à ces critères, mais ils se révèlent difficilement utilisables pour des raisons économiques (réalisation de pièces de fine épaisseur très onéreuse) et mécaniques (leur ductilité les rend incompatibles des environnements thermiques et vibratoires rencontrés dans le domaine d'emploi aéronautique).

L'approche d'un gain de masse par réduction de densité conduit à employer des alliages de magnésium qui présentent des caractéristiques mécaniques proches de celles de l'aluminium, en particulier une rigidité voisine de celle de l'aluminium (le module de Young vaut 45 Gpa pour les alliages de magnésium contre 70 GPa pour l'aluminium). Ainsi, en conservant une épaisseur de paroi identique à celle des boîtiers selon l'état de la technique, il est possible de réaliser des boîtiers d'appareillage électronique plus légers que ceux de l'état de la technique.

Toutefois, un boîtier qui posséderait une structure semblable à celle des boîtiers de l'état de la technique, équipant les aéronefs civils (assemblage de tôles d'alliages d'aluminium pliées), avec des tôles en magnésium d'épaisseur identique ne posséderait toutefois pas une rigidité suffisante pour répondre aux normes d'environnements aéronautiques. Avec cette structure, seul un épaississement des tôles d'alliages de magnésium assurerait une rigidité satisfaisante mais annulerait l'allègement apporté par l'emploi d'un matériau moins dense que l'aluminium.

Par ailleurs, un boîtier qui possède une structure semblable à celle des boîtiers de l'état de la technique équipant les aéronefs militaires (moulage par fonderie à cire perdue ou usinage dans la masse) se révèle très délicat à réaliser. En effet, la coulabilité d'alliages de magnésium à l'état liquide est inférieure à celle de l'aluminium en fusion, ce qui nuit à la réalisation de parties d'un boîtier de faible épaisseur par une méthode de moulage. Par ailleurs, la valeur de module d'Young du magnésium étant inférieure à celle de l'aluminium, la rigidité d'un boîtier en magnésium, est moins bonne que celle d'un boîtier en aluminium identique, même réalisé par fonderie. Enfin, l'alliage de magnésium est difficile à usiner pour deux raisons principales :
- Un risque d'incendie lors de l'usinage si des précautions particulières ne sont pas prises.
- Des déformations résiduelles des parois minces du fait de la structure cristalline de magnésium.

Le but de l'invention est de pallier ces inconvénients. Plus précisément, elle vise à réaliser des boîtiers d'appareillage électronique en matériau moins dense que les alliages d'aluminium, comme des alliages de magnésium, en modifiant pour ce faire la structure de boîtier par rapport à celle des boîtiers de l'état de la technique. Pour ce faire, l'invention conduit à adopter un nouvelle structure de boîtier. Cette nouvelle structure conduit à dissocier des constituants d'un boîtier en deux types:
- une armature, réalisée par fonderie et/ou usinage d'un premier matériau métallique, les armatures assurant la rigidité du boîtier, et
- des parois, réalisées à partir de tôles d'un deuxième matériau métallique apportant un gain de masse.

Plus précisément l'invention a pour objet un boîtier d'appareillage électronique comportant des parois métalliques montées sur une armature, l'armature comportant deux cadres et quatre traverses de longueur identique reliant les deux cadres caractérisé en ce que les cadres sont en fonte d'alliage de magnésium moulée et/ou usinée, et en ce que au moins une des parois est réalisée à partir d'une tôle en alliage de magnésium.

L'invention permet de réaliser des boîtiers d'appareillage électronique compatibles des environnements thermiques, électromagnétiques et vibratoires rencontrés à bord des aéronefs aussi biens civils que militaires, en réalisant un allègement d'environ 30 % de masse par rapport aux boîtiers de l'état de la technique.

D'autres caractéristiques et avantages de l'invention apparaîtront à la lecture de la description détaillée qui suit, faite à titre d'exemple non limitatif et en référence aux dessins annexés dans lesquels :
- la figure 1a représente un boîtier d'appareillage électronique, selon l'état de la technique équipant, équipant un aéronef militaire ;
- la figure 1b représente un boîtier d'appareillage électronique, selon l'état de la technique, équipant un aéronef civil ;
- la figure 2 représente un boîtier d'appareillage électronique selon l'invention ;
- la figure 3a représente une vue en éclaté d'un boîtier d'appareillage électronique selon l'invention,
- la figure 3b représente une vue en semi-éclaté d'un boîtier d'appareillage électronique selon l'invention,

D'une figure à l'autre, les mêmes éléments sont repérés par les mêmes références.

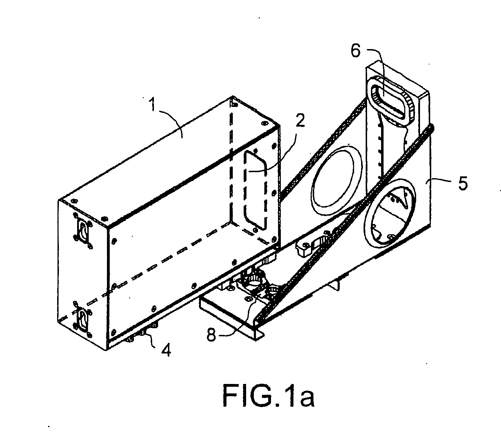

La figure 1a représente un boîtier d'appareillage électronique de l'état de la technique, employé couramment en aéronautique, par exemple pour réaliser des calculateurs de bord d'aéronefs pouvant supporter un environnement sévère, par exemples des aéronefs de type militaire ou des hélicoptères. Le boîtier 1 a une forme parallélépipédique, il comporte sur une de ses faces, une ouverture rectangulaire 2, dans laquelle peut s'enficher un premier connecteur électrique non représenté. Le boîtier 1, comporte sur une autre de ses faces des moyens de fixations 4.

Un châssis d'accueil 5, qui répond également à la norme AER 300, est fixé à la structure d'un aéronef, non représenté sur la figure. Le châssis 2 comporte une ouverture rectangulaire 6, dans laquelle peut s'enficher un deuxième connecteur électrique, non représenté, complémentaire du premier connecteur, et des moyens de fixations 8, complémentaires des moyens de fixations 4. Le boîtier 1, répond à la norme AER 300 qui définit les dimensions du boîtier, et la position et les dimensions de l'ouverture 2.

Le boîtier 1, peut s'ancrer dans le châssis 5. L'ancrage peut être verrouillé par une imbrication des moyens de fixations 4 et 8. L'ancrage est amovible. Le boîtier 1 est soit réalisé en fonderie soit par usinage d'aluminium pour les applications les plus sévères soit en tôlerie auto-raidie.

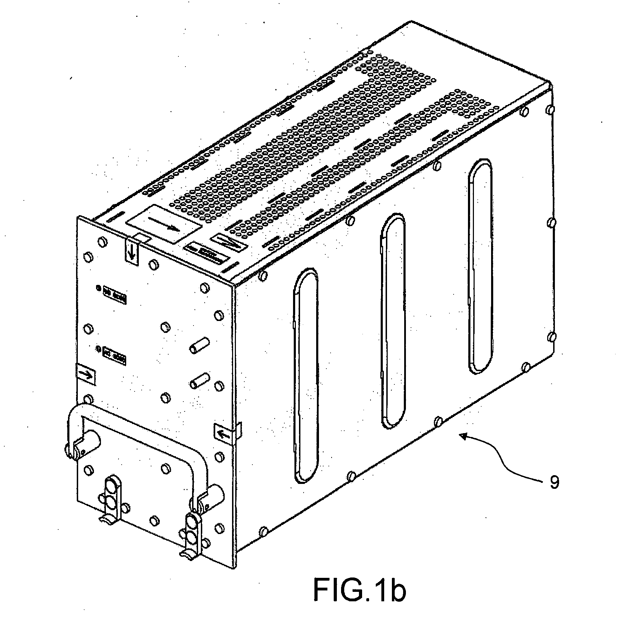

La figure 1b représente une vue en perspective d'un boîtier d'appareillage électronique 9 de type modulaire, réalisé en tôles pliées d'épaisseur environ égale à 2 millimètres, dans un alliage d'aluminium. Les tôles ont une rigidité suffisante pour résister aux relativement faibles niveaux de contraintes mécaniques rencontrés dans le domaine de l'aviation civile. Le châssis est réalisé en un matériau métallique qui peut être différent du matériau constituant le boîtier 1.

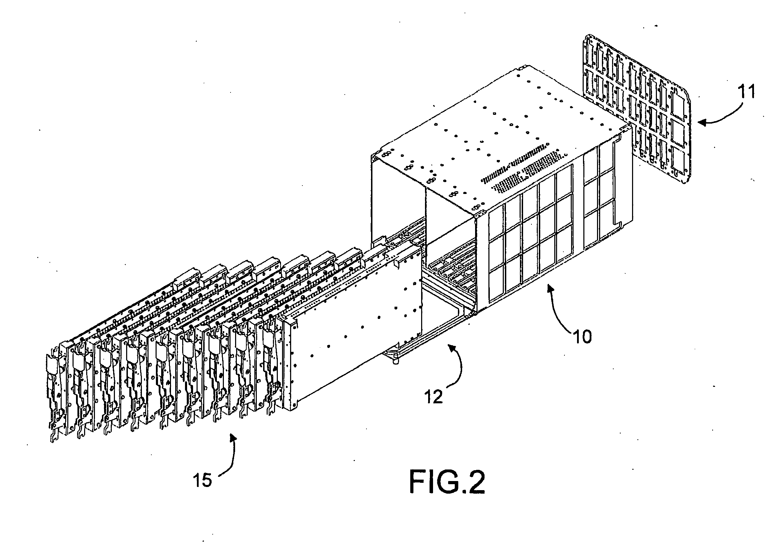

La figure 2 représente un boîtier d'appareillage électronique de type modulaire 10 de l'état de la technique, employé par exemple dans le domaine des aéronefs militaires.

Le boîtier 10 est également de forme parallélépipédique. Une première face 11 du boîtier comporte plusieurs ouvertures pouvant héberger des connecteurs électriques. La première face est destinée à être placée en contact avec un châssis d'accueil fixé à un aéronef. Une deuxième face du boîtier 10, située à l'opposé de la première face peut être retirée temporairement. Le boîtier 10, renferme un ou plusieurs appareillage électronique dont les composants sont montés sur une ou plusieurs cartes 15 de circuit imprimé disposées perpendiculairement à la première et deuxième faces du boîtier 10. Le ou les appareillage électronique dont les composants sont montés sur les cartes 15 de circuit imprimé échangent des signaux électriques avec d'autres appareillage électronique logés dans d'autres boîtiers non représentés sur la figure 2 et ont besoin de ce fait de leur être raccordés électriquement en passant par l'environnement extérieur au boîtier 10.

Les faces du boîtiers hors la première face et la deuxième face, constituent un ensemble d'un seul tenant. Cet ensemble est réalisé par un moulage à cire perdue en alliage d'aluminium. Deux des faces de l'ensemble, se faisant face, ont une épaisseur constante et comportent des orifices pour laisser transiter un fluide caloporteur, par exemple de l'air, à l'intérieur du boîtier pour évacuer la chaleur dissipée par les appareillages électroniques dans le boîtier. Deux autres faces de l'ensemble, se faisant également face ont une épaisseur irrégulière. Sur certaines zones l'épaisseur des faces est réduite pour limiter la masse totale du boîtier.

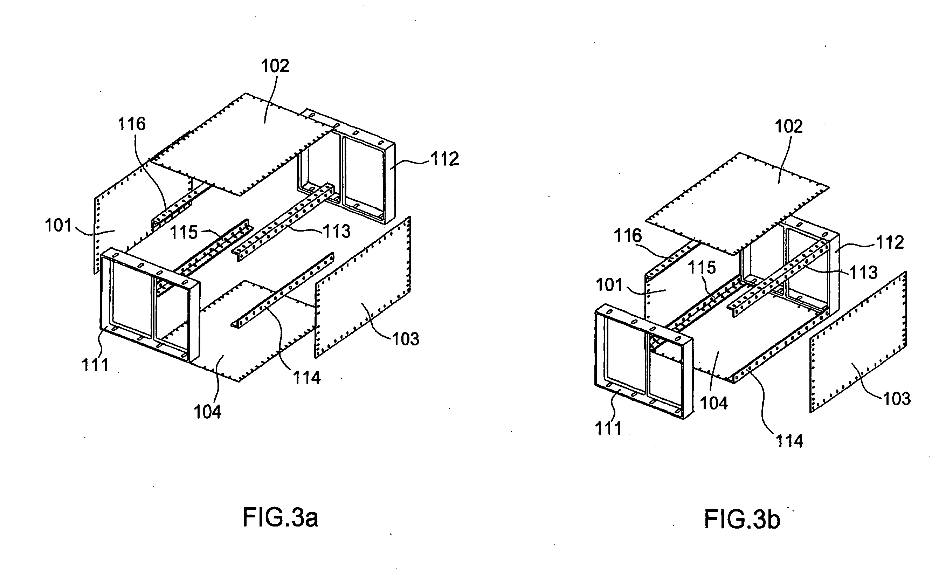

Sur la figure 3, on représente un boîtier selon l'invention 100 en vue éclatée. Le boîtier, de forme parallélépipédique, comporte quatre parois 101, 102, 103, 104, réalisées en tôles d'un premier matériau métallique montée sur une armature 111, 112, 113, 114, 115, 116. L'armature comporte un cadre avant 111, un cadre arrière 112, de forme rectangulaire, réalisés en un deuxième matériau et quatre traverses métalliques 113, 114, 115, 116 d'égale longueur reliant des coins du rectangle formé par le cadre avant 111 et le cadre arrière 112.

Le premier matériau métallique constituant les parois est un alliage de magnésium Une paroi peut être constituée, par exemple, d'une tôle portant la référence AZ 31 HP chez le fabricant français MEL. Les parois ont une épaisseur valant, par exemple, 1,5 millimètre.

Les cadres 111, 112, sont, par exemple, obtenus par fonderie au plâtre par gravité avec l'alliage AZ91E, Les cadres 111, 112 sont plus massifs que les parois : leur épaisseur moyenne vaut par exemple 3 millimètres.

Les traverses 113, 114, 115, 116, représentées sur la figure 3a sont des pièces métalliques réalisées par usinage. Sur la figure 3 les traverses, 113, 114, 115, 116, ont une section en équerre ou « en L » et sont percées pour alléger leur masse, leur section peut également être rectangulaire. Les traverse 113, 114, 115, 116, servent à l'assemblage des parois entre elles aux quatre angle latéraux de la cavité formée par le boîtier.

Avantageusement, les cadres sont obtenus par des moulages à cire perdue.

Avantageusement, les traverses 113, 114, 115, 116, ont une section rectangulaire.

Avantageusement, les traverses 113, 114, 115, 116, ont une section en équerre.

Avantageusement, la fonte d'alliage magnésium constituant les cadres 111, 112, a une teneur en magnésium supérieure à 90%.

Avantageusement, l'alliage de magnésium constituant la tôle a une teneur en magnésium supérieure à 90%.

La structure des boîtiers selon l'invention est hybride, elle rassemble des éléments mécaniques (armatures et parois) pouvant être réalisés par des moyens différents et constitués de moyens différents.

Sur la figure 3b, on représente un boîtier selon l'invention 100 partiellement assemblé. L'assemblage des éléments mécaniques entre eux est réalisé par collage des parois aux bords des cadres. La colle employée pour assembler les parois aux cadres est par exemple une colle conductrice (thermique et électrique). Les parois sont solidarisée entre elles par collage sur les traverses. La rigidité du boîtier est assurée par les cadres.

Avantageusement, les parois métalliques 101, 102, 103, 104, sont montées sur l'armature grâce à une colle conductrice

La continuité électrique du boîtier est assuré par des rivets en alliage d'aluminium qui traversent simultanément les parois et les cadres. Plusieurs rivets sont employés pour lier une paroi à un cadre.

Avantageusement, le boîtier comporte des rivets métalliques traversant les cadres 11, 112 et les parois métalliques 101, 102, 103, 104.

Avantageusement, les rivets métalliques sont en alliage d'aluminium.

## Revendications

1. Boîtier d'appareillage électronique comportant des parois métalliques (101), (102), (103), (104), montées sur une armature, l'armature comportant deux cadres (111), (112) et quatre traverses (113), (114), (115), (116), de longueur identique reliant les deux cadres (111), (112) **caractérisé en ce que** :
les cadres (111), (112) sont en fonte d'alliage de magnésium moulée et/ou usinée, et **en ce que** au moins une des parois (101), (102), (103), (104), est réalisée à partir d'une tôle en alliage de magnésium.

2. Boîtier d'appareillage électronique selon la revendication 1, **caractérisé en ce que** les parois métalliques (101), (102), (103), (104), sont montées sur l'armature grâce à une colle conductrice.

3. Boîtier d'appareillage électronique selon l'une des revendications 1 à 2, **caractérisé en ce que** les cadres (111), (112), sont obtenus par des moulages à cire perdue.

4. Boîtier d'appareillage électronique selon l'une des revendications 1 à 3, **caractérisé en ce que** les traverses (113), (114), (115), (116), ont une section rectangulaire.

5. Boîtier d'appareillage électronique selon l'une des revendications 1 à 3, **caractérisé en ce que** les traverses (113), (114), (115), (116), ont une section en équerre

6. Boîtier d'appareillage électronique selon l'une des revendications 1 à 5, **caractérisé en ce qu'**il comporte des rivets métalliques traversant les cadres (111), (112) et les parois métalliques (101), (102), (103), (104).

7. Boîtier d'appareillage électronique selon la revendication 6, **caractérisé en ce que** les rivets métalliques sont en alliage d'aluminium.

8. Boîtier d'appareillage électronique selon l'une des revendications 1 ou 7, **caractérisé en ce que** la fonte d'alliage magnésium constituant les cadres (111), (112), a une teneur en magnésium supérieure à 90%.

9. Boîtier d'appareillage électronique selon l'une des revendications 1 ou 7, **caractérisé en ce que** l'alliage de magnésium constituant la tôle a une teneur en magnésium supérieure à 90%.

10. Boîtier d'appareillage électronique selon l'une des revendications 1 ou 7, **caractérisé en ce que** les traverses (113), (114), (115), (116), sont en alliage d'aluminium et sont réalisées par usinage.

## Claims

1. An electronic equipment casing comprising metal walls (101), (102), (103), (104) mounted on a framework construction, the framework construction comprising two frames (111), (112) and four crosspieces (113), (114), (115), (116) identical in length linking the two frames (111), (112), **characterised in that**:
the frames (111), (112) are of moulded and/or machined cast magnesium alloy, and **in that** at least one of the walls (101), (102), (103), (104) is made from a magnesium alloy sheet.

2. An electronic equipment casing according to claim 1, **characterised in that** the metal walls (101), (102), (103), (104) are mounted on the framework construction by means of a conductive adhesive.

3. An electronic equipment casing according to one of claims 1 to 2, **characterised in that** the frames (111), (112) are obtained using lost wax moulding.

4. An electronic equipment casing according to one of claims 1 to 3, **characterised in that** the crosspieces (113), (114), (115), (116) are of rectangular section.

5. An electronic equipment casing according to one of claims 1 to 3, **characterised in that** the crosspieces (113), (114), (115), (116) are of right-angled section.

6. An electronic equipment casing according to one of claims 1 to 5, **characterised in that** it comprises metal rivets passing through the frames (111), (112) and the metal walls (101), (102), (103), (104).

7. An electronic equipment casing according to claim 6, **characterised in that** the metal rivets are made of aluminium alloy.

8. An electronic equipment casing according to one of claims 1 or 7, **characterised in that** the cast magnesium alloy of which the frames (111), (112) consist has a magnesium content greater than 90%.

9. An electronic equipment casing according to one of claims 1 or 7, **characterised in that** the magnesium alloy of which the sheet consists has a magnesium content greater than 90%.

10. An electronic equipment casing according to one of claims 1 or 7, **characterised in that** the crosspieces (113), (114), (115), (116) are made of aluminium alloy and are produced by machining.

## Patentansprüche

1. Gehäuse für ein elektronisches Gerät, wobei das Gehäuse metallische Wände (101), (102), (103), (104) umfasst, die an einer Armatur montiert sind, die zwei Rahmen (111), (112) und vier Traversen (113), (114), (115), (116) von identischer Länge umfasst, die die zwei Rahmen (111), (112) miteinander verbinden, **dadurch gekennzeichnet, dass**:
die Rahmen (111), 112) aus einem geformten und/oder spanend bearbeiteten Magnesiumlegierungsgussteil bestehen, und **dadurch**, dass wenigstens eine der Wände (101), (102), (103), (104) aus einem Blech aus Magnesiumlegierung gefertigt ist.

2. Gehäuse für ein elektronisches Gerät nach Anspruch 1, **dadurch gekennzeichnet, dass** die metallischen Wände (101), (102), (103), (104) mit einem leitenden Klebstoff auf der Armatur montiert sind.

3. Gehäuse für ein elektronisches Gerät nach einem der Ansprüche 1 bis 2, **dadurch gekennzeichnet, dass** die Rahmen (111), (112) durch Gießen mit verlorenen Wachsformen erhalten werden.

4. Gehäuse für ein elektronisches Gerät nach einem der Ansprüche 1 bis 3, **dadurch gekennzeichnet, dass** die Traversen (113), (114), (115), (116) einen rechteckigen Querschnitt haben.

5. Gehäuse für ein elektronisches Gerät nach einem der Ansprüche 1 bis 3, **dadurch gekennzeichnet, dass** die Traversen (113), (114), (115), (116) einen abgewinkelten Querschnitt haben.

6. Gehäuse für ein elektronisches Gerät nach einem der Ansprüche 1 bis 5, **dadurch gekennzeichnet, dass** es metallische Nieten umfasst, die durch die Rahmen (111), (112) und die metallischen Wände (101), (102), (103), (104) verlaufen.

7. Gehäuse für ein elektronisches Gerät nach Anspruch 6, **dadurch gekennzeichnet, dass** die metallischen Nieten aus Aluminiumlegierung bestehen.

8. Gehäuse für ein elektronisches Gerät nach einem der Ansprüche 1 oder 7, **dadurch gekennzeichnet, dass** das die Rahmen (111), (112) bildende Magnesiumlegierungsgussteil einen Magnesiumgehalt von mehr als 90% hat.

9. Gehäuse für ein elektronisches Gerät nach einem der Ansprüche 1 oder 7, **dadurch gekennzeichnet, dass** die das Blech bildende Magnesiumlegierung einen Magnesiumgehalt von mehr als 90% hat.

10. Gehäuse für ein elektronisches Gerät nach einem der Ansprüche 1 oder 7, **dadurch gekennzeichnet, dass** die Traversen (113), (114), (115), (116) aus Aluminiumlegierung bestehen und durch spanende Bearbeitung gefertigt werden.
